# FASCICULE DE BREVET EUROPEEN

(11) **EP 3 449 305 B1**
(45) Date de publication et mention de la délivrance du brevet: **08.11.2023**
(21) Numéro de dépôt: 17719583.1
(22) Date de dépôt: 25.04.2017
(51) Int. Cl.: G02B 27/01, G02B 6/42, H05K 1/02

(54) **AFFICHEUR COMPRENANT UN CAPTEUR DE LUMIÈRE**
ANZEIGE MIT EINEM LICHTSENSOR
DISPLAY COMPRISING A LIGHT SENSOR

(30) Priorité: 26.04.2016 FR 1653673
(43) Date de publication de la demande: 06.03.2019
(73) Titulaire: Valeo Comfort and Driving Assistance, 94000 Créteil (FR)
(72) Inventeur: GRANDCLERC, François, 94046 Créteil CEDEX (FR); MERMILLOD, Pierre, 94046 Créteil CEDEX (FR)
(74) Mandataire: Delplanque, Arnaud
(86) Numéro de dépôt international: PCT/EP2017/059837
(87) Numéro de publication internationale: WO 2017/186745

(56) Documents cités:
- EP-A1- 2 849 175
- JP-A- H06 144 081
- JP-A- 2004 314 860
- JP-A- 2011 223 238
- JP-U- H0 647 027

## Description

### DOMAINE TECHNIQUE AUQUEL SE RAPPORTE L'INVENTION

La présente invention concerne un afficheur, notamment un afficheur tête haute.

Elle concerne plus particulièrement un afficheur selon la revendication

Elle s'applique de manière particulièrement intéressante dans un véhicule automobile.

### ARRIÈRE-PLAN TECHNOLOGIQUE

Pour le conducteur d'un véhicule automobile, il est particulièrement confortable de pouvoir visualiser des informations relatives au fonctionnement du véhicule, à l'état du trafic, ou autres, sans avoir pour cela à détourner son regard de la route faisant face au véhicule.

Il est connu dans ce but d'équiper un véhicule automobile avec un afficheur dit tête haute. Dans un tel afficheur, une image comportant les informations à afficher est générée par une unité de génération d'image. Cette image est alors superposée visuellement à l'environnement faisant face au véhicule, au moyen d'une réflexion partielle sur une lame semi-transparente située devant le conducteur, telle qu'un combineur disposé entre le parebrise du véhicule et les yeux du conducteur.

Afin que les informations ainsi affichées soient suffisamment lumineuses pour être correctement visualisées, sans pour autant risquer d'éblouir le conducteur, il est nécessaire d'adapter la luminosité de l'image ainsi superposée à l'environnement extérieur du véhicule à la luminosité de cet environnement lui-même, qui varie fortement entre une conduite de jour et une conduite de nuit ou dans un tunnel.

Il est connu pour cela de munir l'afficheur tête haute d'un capteur de lumière, une unité de commande commandant alors la luminosité de l'image générée en fonction d'un signal acquis par le capteur de lumière, de manière à adapter la luminosité de cette image à une luminosité ambiante.

Plus particulièrement, il est connu de disposer le capteur de lumière à l'intérieur d'un boitier de l'afficheur. Une ouverture est alors ménagée dans le boitier de l'afficheur pour qu'une partie du rayonnement lumineux extérieur pénètre dans le boitier, jusqu'au capteur de lumière. Mais l'intérieur du boitier de l'afficheur est alors visible pour un utilisateur, dégradant ainsi l'apparence extérieure de

Un dispositif similaire est connu de EP 2 849 175 A1.

### OBJET DE L'INVENTION

Dans ce contexte, la présente invention propose un afficheur tel que défini en introduction, comprenant en outre un guide de lumière situé à l'intérieur du boitier de l'afficheur, présentant une face d'entrée et conformé pour collecter au niveau de sa face d'entrée un rayonnement lumineux provenant de l'extérieur du boitier de l'afficheur, et pour guider ledit rayonnement lumineux jusqu'audit capteur.

Il est intéressant de pouvoir disposer le capteur de lumière à l'intérieur du boitier, notamment pour satisfaire des contraintes de liaison électrique et mécanique de ce capteur.

Le guide de lumière autorise avantageusement de déporter le capteur de lumière à l'intérieur du boitier de l'afficheur, sans que cela ne rende l'intérieur du boitier visible pour un utilisateur, ce qui est particulièrement intéressant en termes d'apparence extérieure de l'afficheur.

Le guide de lumière assure par ailleurs une collection efficace du rayonnement lumineux provenant de l'extérieur du boitier de l'afficheur et dont l'intensité lumineuse est mesurée par le capteur de lumière.

Le boitier de l'afficheur présente une ouverture, traversée par ledit rayonnement lumineux pour parvenir jusqu'au capteur de lumière.

Selon une caractéristique obligatoire de l'afficheur, la face d'entrée du guide de lumière est située au niveau de cette ouverture.

L'afficheur présente alors une apparence extérieure avantageusement lisse et homogène.

En outre, le guide de lumière empêche alors l'entrée de corps étrangers, tels que des particules de poussière, à l'intérieur du boitier de l'afficheur, et masque de manière optimale, au regard d'un utilisateur, l'intérieur dudit boitier.

Selon une autre caractéristique obligatoire l'afficheur comprend également un ensemble optique de projection adapté pour projeter l'image générée par l'unité de génération d'image, en direction d'une lame semi-transparente pour, avec la lame semi-transparente, former une image virtuelle dans le champ de vision de l'utilisateur.

On peut prévoir alors que le guide de lumière est distinct de la lame semi-transparente. On peut prévoir en outre que le guide de lumière est disjoint de la lame semi-transparente.

Il est préférable d'éviter qu'une partie de la lumière émise par l'unité de génération d'image, et réfléchie ensuite en partie sur la lame semi-transparente, n'atteigne ledit capteur, car cette lumière perturberait la mesure de luminosité ambiante réalisée au moyen de ce capteur.

Le fait que le guide de lumière est distinct, voire disjoint, de la lame semi-transparente évite alors avantageusement que la lumière émise par l'unité de génération d'image n'atteigne le capteur de lumière.

La demanderesse a constaté par ailleurs que lorsque l'afficheur équipe un véhicule, un rayonnement lumineux secondaire :
- présentant des variations d'intensité abruptes et répétées, et
- provenant de l'extérieur du véhicule sans pour autant provenir d'une région située dans le champ de vision du conducteur,
peut être incident sur l'afficheur.

Une telle situation est rencontrée notamment lors d'un trajet du véhicule dans un tunnel muni de dispositifs d'éclairage disposés à intervalles réguliers le long du tunnel, ou lors du passage du véhicule le long de câbles de suspension d'un pont ou d'autres éléments de construction disposés alternativement le long du trajet du véhicule.

Les variations d'intensité lumineuse de ce rayonnement lumineux secondaire sont alors susceptibles d'être captées par le capteur de lumière, entraînant alors une variation parasite, en l'occurrence un clignotement, de la luminosité de l'image générée par l'unité de génération d'image.

Pour remédier notamment à cet inconvénient, on peut prévoir que le guide de lumière est conformé de sorte que le rayonnement lumineux qu'il est adapté à collecter provient d'une zone située approximativement dans la direction dans laquelle est formée ladite image virtuelle.

Le rayonnement lumineux, c'est-à-dire la lumière, provenant de cette zone est perçu par l'utilisateur lorsqu'il regarde en direction de ladite image virtuelle. Il est donc intéressant que, grâce à ce guide de lumière, le capteur reçoive une partie au moins du rayonnement lumineux provenant de cette zone, afin de pouvoir adapter la luminosité de l'image virtuelle à la luminosité de son environnement visuel.

Le guide de lumière conformé de la sorte permet en outre de collecter sélectivement la lumière provenant de cette zone, en éliminant la lumière provenant d'autres régions de l'environnement extérieur de l'afficheur. Grâce à ce caractère sélectif du guide de lumière, le clignotement précité de l'image générée par l'afficheur est alors avantageusement limité.

D'autres caractéristiques non limitatives et avantageuses de l'afficheur conforme à l'invention sont selon les revendications dépendantes.

### DESCRIPTION DÉTAILLÉE D'UN EXEMPLE DE RÉALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique en coupe, de côté, d'un afficheur mettant en oeuvre les enseignements de l'invention ; et
- la figure 2 est une vue schématique de détail de la zone II de la figure 1.

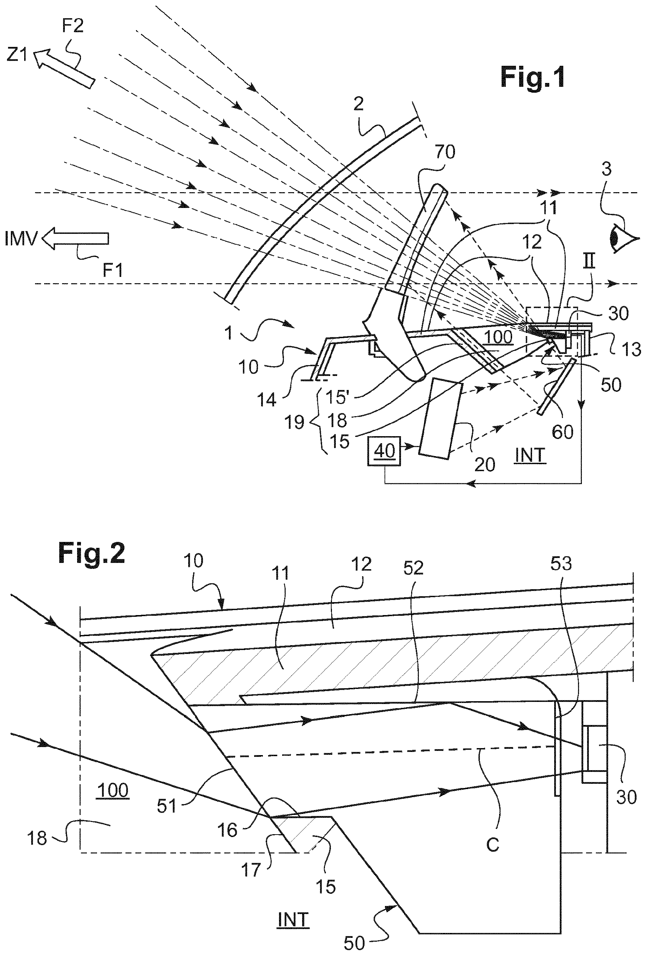

La figure 1 représente schématiquement les éléments principaux d'un afficheur 1, ici un afficheur tête haute, destiné à équiper un véhicule, par exemple un véhicule automobile, un train, un bateau tel qu'une péniche, un tramway ou un bus.

L'afficheur 1 comprend une unité de génération d'image 20, comportant par exemple un dispositif de rétroéclairage éclairant un écran à cristaux liquides (ou LCD pour "Liquid Crystal Display") à transistors en couche mince (ou TFT pour "Thin-Film Transistor").

Ici, l'afficheur 1 comprend également un ensemble optique de projection adapté pour projeter une image générée par l'unité de génération d'image 20, en direction d'une lame semi-transparente pour, avec la lame semi-transparente, former une image virtuelle IMV dans le champ de vision d'un utilisateur. L'image virtuelle IMV reproduit l'image générée au niveau de l'unité de génération d'image 20.

On peut ainsi afficher des informations dans le champ de vision de l'utilisateur sans que celui-ci n'ait à détourner le regard. En pratique, cet utilisateur correspond ici au conducteur du véhicule.

L'ensemble optique de projection comprend ici un miroir de repliement 60. En variante, il pourrait comprendre une pluralité de miroirs et/ou d'autres éléments optiques.

La lame semi-transparente est ici mise en oeuvre sous la forme d'un combineur 70, c'est-à-dire d'une plaque semi-transparente, disposée ici entre le pare-brise 2 du véhicule et les yeux 3 du conducteur.

On peut prévoir en variante que l'ensemble optique de projection projette directement l'image générée par l'unité de génération d'image en direction du pare-brise du véhicule, le combineur précité étant alors omis. Dans ce cas, la lame semi-transparente est ainsi mise en oeuvre sous la forme du pare-brise du véhicule.

L'expression « lame semi-transparente » désigne ici une lame au moins partiellement transparente, présentant un niveau de transparence compris entre celui d'une lame complètement transparente, et celui d'une lame complètement opaque.

En plus d'être semi-transparente, cette lame est semi-réfléchissante, permettant ainsi de renvoyer en direction de l'utilisateur une partie au moins de la lumière produite par l'unité de génération d'image 20, comme cela est représenté schématiquement sur la figure 1.

L'image virtuelle IMV, formée dans le champ de vision de l'utilisateur par l'ensemble optique de projection et la lame semi-transparente, est située à l'opposé de l'utilisateur par rapport à la lame semi-transparente, par exemple à quelques mètres de la lame semi-transparente.

Ici, pour le conducteur du véhicule, l'image virtuelle IMV se forme au sein de l'environnement routier faisant face au véhicule, se superposant ainsi visuellement à cet environnement.

La direction dans laquelle est formée l'image virtuelle IMV, c'est-à-dire la direction dans laquelle est située l'image virtuelle IMV par rapport à l'afficheur 1, est repérée schématiquement sur la figure 1 par la flèche F1.

L'afficheur 1 comprend également un capteur 30 de lumière, tel qu'une photodiode ou un phototransistor, adapté pour délivrer un signal représentatif d'une intensité lumineuse qu'il reçoit, et disposé de manière à recevoir un rayonnement lumineux provenant de l'extérieur de l'afficheur 1.

L'afficheur 1 est adapté à ce que la luminosité de l'image générée par l'unité de génération d'image 20 soit commandée en fonction du signal délivré par le capteur 30 de lumière.

La luminosité de l'image générée peut ainsi être adaptée à une luminosité ambiante, mesurée au moyen du capteur 30, ce qui permet d'assurer la visibilité de l'image virtuelle IMV, même lorsque la luminosité ambiante varie.

Plus précisément, l'afficheur 1 est adapté ici à ce que la luminosité de l'image générée soit d'autant plus grande que l'intensité lumineuse reçue par ledit capteur (30) est grande.

Pour cela, l'afficheur 1 comprend ici une unité de commande 40, programmée pour commander la luminosité de l'image générée par l'unité de génération d'image 20, en fonction du signal délivré par ce capteur 30. En l'occurrence, l'unité de commande 40 est programmée pour commander la luminosité de l'image générée de sorte qu'elle est d'autant plus grande que l'intensité lumineuse reçue par ledit capteur 30 est grande.

Pour adapter ainsi la luminosité de l'image générée, il est prévu ici de commander l'amplitude moyenne d'un courant électrique, ou d'une tension électrique, d'alimentation du dispositif de rétroéclairage de l'unité de génération d'image 20.

Ici, plus précisément, l'unité de commande 40 est programmée pour moduler la largeur d'impulsions d'un courant électrique d'alimentation du dispositif de rétroéclairage de l'unité de génération d'image 20, de sorte que l'intensité moyenne (au cours du temps) de ce courant électrique est d'autant plus grande que l'intensité lumineuse mesurée par le capteur 30 est grande.

Le lien entre l'intensité lumineuse mesurée par le capteur 30 et l'intensité moyenne correspondante, du courant électrique appliqué au dispositif de rétroéclairage, est par exemple mémorisée sous la forme d'une table de correspondance, dans une mémoire de l'unité de commande 40.

En variante, l'unité de commande peut être omise, la commande de l'unité de génération d'image étant alors réalisée, de manière comparable à ce qui a été décrit ci-dessus, au moyen d'un module électronique extérieur à l'afficheur.

L'afficheur 1 comprend également un boitier 10 dans lequel sont logés l'unité de génération d'image 20 et le miroir de renvoi 60.

Ce boitier 10, représenté partiellement sur la figure 1, cache au regard de l'utilisateur les éléments de l'afficheur 1 logés dans le boitier 10, grâce à quoi l'afficheur présente extérieurement une apparence unifiée et homogène. Le boitier 10 protège également ces éléments de l'afficheur 1 de corps étrangers tels que des poussières.

Le boitier 10 est formé de plusieurs parois 11, 13, 14, optiquement opaques, séparant l'intérieur INT du boitier 10 de l'extérieur de celui-ci.

Le boitier 10 comprend en particulier une paroi principale 11 supérieure située du côté de la lame semi-transparente en position d'usage. En position d'usage, la lame semi-transparente, ici le combineur 70, s'étend à l'extérieur du boitier 10, en saillie par rapport à cette paroi principale 11 supérieure. Cette paroi principale 11 supérieure est ici globalement plane.

Le terme « supérieure » désigne des éléments, ou parties d'éléments de l'afficheur, situés, par rapport au boitier 10 (plus précisément par rapport à l'intérieur INT du boitier 10), d'un même côté du boitier que la lame semi-transparente en position d'usage. De tels éléments, en particulier la paroi principale 11 supérieure, peuvent ainsi être visibles pour l'utilisateur. Dans le cas particulier où l'afficheur 1 est installé dans le véhicule à proximité d'un tableau de bord de ce dernier (d'un côté du pare-brise 2 opposé à un toit du véhicule), le terme « supérieure » désigne des éléments, ou parties d'éléments de l'afficheur, situés vers le haut de l'afficheur 1, relativement à une direction verticale ascendante.

On peut prévoir de manière optionnelle que le combineur 70 est monté mobile par rapport au boitier 10 entre sa position d'usage et une position rétractée, le combineur 70 dans sa position rétractée étant logé dans le boitier 10.

Le capteur 30 de lumière est également logé dans le boitier 10 de l'afficheur. Ici, plus précisément, le capteur 30 de lumière est situé à l'intérieur INT du boitier, au voisinage de la paroi principale 11 supérieure du boitier mentionnée ci-dessus.

Le capteur 30 de lumière est monté fixement sur une plaque-support de circuit imprimé (non représentée). Pour autoriser une plus grande liberté de positionnement du capteur 30 de lumière au sein de l'afficheur, cette plaque-support de circuit imprimé est ici distincte d'une autre plaque-support de circuit imprimée, principale, de l'afficheur, à laquelle elle est connectée par un câble électrique. La plaque-support de circuit imprimée principale de l'afficheur est par exemple utilisée pour monter l'unité de commande 40 et/ou les composants électroniques nécessaires pour générer le courant électrique (ici modulé en largeur d'impulsions) d'alimentation de l'unité de génération d'image 20. Le signal délivré par le capteur 30 de lumière est transmis jusqu'à la plaque-support de circuit imprimée principale au moyen de la connexion électrique mentionnée ci-dessus.

Le boitier 10 présente une ouverture 16 (visible sur la figure 2) autorisant le passage, de l'extérieur vers l'intérieur INT du boitier 10, du rayonnement lumineux reçu par le capteur 30.

Selon une caractéristique particulièrement remarquable, l'afficheur 1 comprend également un guide de lumière 50 situé à l'intérieur INT du boitier 10 de l'afficheur, présentant une face d'entrée 51 et conformé pour collecter au niveau de sa face d'entrée 51 un rayonnement lumineux provenant de l'extérieur du boitier 10 de l'afficheur, et pour guider ledit rayonnement lumineux jusqu'au capteur 30 de lumière.

Ce guide de lumière 50 autorise avantageusement de déporter le capteur 30 de lumière à l'intérieur INT du boitier de l'afficheur 1, sans pour autant rendre l'intérieur INT de ce boitier soit visible pour l'utilisateur, ce qui est particulièrement intéressant en termes d'apparence extérieure de l'afficheur 1.

Le guide de lumière 50 assure par ailleurs une collection efficace du rayonnement lumineux provenant de l'extérieur du boitier 10 de l'afficheur, dont l'intensité lumineuse est mesurée par le capteur 30 de lumière.

Le guide de lumière 50 est ici distinct, et disjoint de la lame semi-transparente. Cela évite que la lumière émise par l'unité de génération d'image 20, et qui traverse la lame semi-transparente ou est réfléchie par celle-ci, n'atteigne le capteur 30 de lumière. Cet arrangement est particulièrement intéressant, car si une partie de la lumière émise par l'unité de génération d'image atteignait le capteur 30 de lumière, cela perturberait la mesure de luminosité ambiante réalisée au moyen de ce capteur 30.

La face d'entrée 51 du guide de lumière 50 est située ici au niveau de l'ouverture 16 ménagée dans le boitier 10 pour le passage du rayonnement lumineux atteignant le capteur 30 de lumière. Plus précisément, comme on peut le voir sur la figure 2, la face d'entrée 51 du guide de lumière 50 affleure ici la face extérieure 17 de la paroi 15 du boitier dans laquelle est ménagée cette ouverture 16.

Le guide de lumière 50 est conformé ici de sorte que le rayonnement lumineux qu'il est adapté à collecter provient d'une zone Z1 située approximativement dans la direction dans laquelle est formée l'image virtuelle IMV.

La direction dans laquelle est située la zone Z1, par rapport à l'afficheur 1, est repérée par la flèche F2 sur la figure 1. Cette direction est proche de la direction dans laquelle est formée ladite image virtuelle IMV.

La zone Z1 peut toutefois être légèrement décalée angulairement par rapport à l'image virtuelle IMV, par exemple d'un angle compris entre 0 degrés et 45 degrés.

Comme la direction dans laquelle est située la zone Z1 est proche de la direction dans laquelle est formée l'image virtuelle IMV, la zone Z1 est située pour l'utilisateur, dans le voisinage visuel de l'image virtuelle IMV. Ici par exemple, d'un point de vue visuel, la zone Z1 est située légèrement au dessus de l'image virtuelle IMV, dans le champ de vision de l'utilisateur (comme cela est illustré schématiquement sur la figure 1).

La lumière provenant de cette zone Z1 est donc perçue par l'utilisateur lorsqu'il regarde en direction de ladite image virtuelle IMV.

Grâce au guide de lumière 50, une partie au moins du rayonnement lumineux provenant de cette zone Z1 atteint le capteur 30 de lumière. Le guide de lumière 50 empêche par ailleurs la lumière provenant d'autres régions de l'environnement extérieur de l'afficheur 1 de parvenir jusqu'au capteur 30 de lumière.

Grâce à cet arrangement, la luminosité de l'image virtuelle IMV est donc ajustée en fonction de la luminosité de la zone Z1, qui est située visuellement au voisinage de cette image IMV. Cette disposition est donc particulièrement intéressante, puisqu'elle assure une visibilité optimale de l'image virtuelle IMV pour l'utilisateur.

On peut prévoir également, de manière optionnelle, que la zone Z1 est non seulement située dans une direction proche de celle dans laquelle se forme l'image virtuelle IMV, mais qu'en outre cette zone Z1 environne ladite image virtuelle IMV. Autrement formulé, on peut prévoir que la zone Z1 est située, dans l'environnement faisant face à l'utilisateur, autour de l'image virtuelle IMV.

Le fait que le guide de lumière 50 collecte de manière sélective le rayonnement lumineux provenant de la zone Z1 est obtenu notamment grâce à un positionnement approprié du guide de lumière 50, décrit plus en détail ci-dessous.

On peut prévoir notamment pour cela, comme ici, que le boitier 10 présente une face externe 12, et, au niveau de cette face externe 12, un renfoncement 100, la face d'entrée 51 du guide de lumière 50 étant située au niveau de ce renfoncement 100. Autrement formulé, on peut prévoir que le boitier 10 présente, au niveau de cette face externe 12, une partie s'étendant en retrait (ledit renfoncement) par rapport à cette face externe, formant une cavité ou un conduit. La face d'entrée 51 du guide de lumière 50, située au niveau de ce renfoncement 100 (en retrait par rapport à la face externe 12 du boitier 10 de l'afficheur 1), est alors abritée au moins en partie d'un rayonnement lumineux, autre que celui provenant de la zone Z1, environnant l'afficheur.

Pour renforcer encore cet effet, on peut prévoir comme ici que la paroi 15, au niveau de laquelle est située la face d'entrée 51 du guide de lumière, s'étend vers l'intérieur INT du boitier 10 en surplomb par rapport à ladite face externe 12 du boitier, c'est-à-dire en formant avec la face externe 12 un angle aigu inférieur à 90 degrés. La face externe 12 du boitier s'étend alors, par rapport à l'intérieur INT du boitier 10, au dessus de la face d'entrée 51 du guide de lumière, et l'abrite ainsi en partie du rayonnement lumineux susmentionné.

La face d'entrée 51 du guide de lumière 50 est située ici plus précisément sur ladite paroi 15, à proximité de la face externe 12 du boitier de l'afficheur, comme illustré sur la figure 2.

Ici, l'afficheur 1 comprend également un conduit 19 (figure 1), s'étendant depuis la face externe 12 du boitier en direction de l'intérieur INT du boitier 10. Ce conduit 19 débouche au niveau de la face externe 12 du boitier 10. Ce conduit 19 canalise un rayonnement lumineux émis par l'unité de génération d'image 20 et renvoyé vers le combineur 70 par l'ensemble optique de projection pour former l'image virtuelle IMV.

Le conduit 19 est formé de plusieurs parois 15, 15', 18, optiquement opaques. Il évite notamment qu'un rayonnement lumineux parasite, autre que celui destiné à former l'image virtuelle IMV, ne sorte du boitier de l'afficheur.

La paroi 15 mentionnée précédemment, au niveau de laquelle est située la face d'entrée 51 du guide de lumière 50, correspond ici à l'une des parois 15, 15', 18 formant ce conduit 19.

Par ailleurs, la face externe 12 précitée est située ici, par rapport à l'intérieur INT du boitier 10, d'un même côté du boitier 10 que la lame semi-transparente 70 en position d'usage. Plus précisément, cette face externe 12 est présentée ici par la paroi principale 11 supérieure du boitier 10.

La face d'entrée 51 du guide de lumière 50 est alors positionnée de manière particulièrement bien adaptée, d'un point de vue optique, pour récolter la lumière provenant d'une direction proche de la direction de formation de l'image virtuelle IMV, tout en étant abritée au mieux d'autres rayonnements lumineux.

Dans cette configuration, la face d'entrée 51 du guide de lumière 50 est alors située, par rapport à la lame semi-transparente, d'un côté opposé à l'image virtuelle IMV.

Le guide de lumière 50, positionné comme cela a été décrit ci-dessus, peut maintenant être décrit plus en détail.

Le rayonnement lumineux provenant de la zone Z1 suit, dans le guide de lumière 50, un chemin de propagation c moyen qui relie la face d'entrée 51 du guide de lumière à une face de sortie 53 située en vis-à-vis du capteur 30 de lumière.

La face d'entrée 51 du guide de lumière 50 présente ici une orientation adaptée pour dévier par réfraction ce rayonnement lumineux, de manière à le coupler dans le guide de lumière 50. Autrement formulé, le guide de lumière 50 présente ici une orientation adaptée pour modifier par réfraction la direction de propagation moyenne de ce rayonnement de manière qu'elle coïncide dans le guide de lumière avec celle définie le chemin de propagation c .

Cette déviation par réfraction est obtenue au moyen d'une inclinaison adaptée de la face d'entrée 51, par rapport à la direction dans laquelle est située la zone Z1.

Pour permettre cette déviation par réfraction, la face d'entrée 51 est orientée de manière oblique, également par rapport à la direction définie par le chemin de propagation c (au niveau de la face d'entrée 51 du guide de lumière). Le guide de lumière 50 présentant ainsi une forme de biseau au niveau de sa face d'entrée 51.

Le chemin de propagation c est ici approximativement rectiligne. Ainsi, l'orientation de la face d'entrée 51 du guide de lumière est adaptée plus précisément, ici, pour dévier par réfraction le rayonnement lumineux provenant de ladite zone Z1, en direction du capteur 30 de lumière.

Dans une variante non représentée, on peut prévoir que la face d'entrée du guide de lumière est approximativement perpendiculaire à la direction dans laquelle est située la zone Z1 vue de la face d'entrée 51, au lieu d'être orientée de manière oblique par rapport à cette direction comme dans les modes de réalisation décrits ci-dessus. Selon cette variante, lors de son entrée dans le guide de lumière, la lumière provenant de cette zone Z1 ne serait alors, en moyenne, pas déviée. Dans le cadre de cette variante, le chemin de propagation s'étend alors, à partir de la face d'entrée du guide de lumière, dans une direction sensiblement parallèle à celle dans laquelle est située la zone Z1 vue de la face d'entrée 51.

De manière optionnelle, on peut prévoir que la face d'entrée 51 est bombée, pour augmenter l'efficacité et la sélectivité de collection du guide de lumière 50. La face d'entrée 51 peut en particulier être convexe, afin de remplir la fonction optique d'une lentille convergente.

La face de sortie 53 est quant à elle approximativement plane et orthogonale au chemin de propagation c.

Le capteur 30 de lumière est ici disposé à proximité de la paroi principale 11 supérieure du boitier (du côté intérieur du boitier), de même que la face d'entrée 51 du guide de lumière, si bien que le chemin de propagation c susmentionné est approximativement parallèle à cette paroi principale 11 supérieure du boitier.

La surface sensible du capteur 30 s'étend ici approximativement perpendiculairement à cette paroi principale 11 supérieure.

Le guide de lumière 50 présente également, ici, une face supérieure 52 reliant sa face d'entrée 51 et sa face de sortie 53, et s'étendant approximativement parallèlement au chemin de propagation c. Cette face supérieure 52 remplit une fonction de guidage, par réflexion totale interne, du rayonnement lumineux collecté par le guide de lumière 50. A cette fin, la face supérieure 52 est polie.

Les faces d'entrée 52 et de sortie 53, ainsi ici que les autres faces du guide de lumière 50 sont également polies.

Le guide de lumière 50 est par exemple réalisé par injection dans un moule d'une matière plastique transparente telle que du polycarbonate transparent ou du polyméthacrylate de méthyle (ou PMMA) transparent.

La face de sortie 53 du guide de lumière 50 est ici disjointe du capteur 30 de lumière, un mince intervalle étant prévu entre le capteur 30 et la face de sortie 53. Cet arrangement empêche avantageusement la transmission de vibrations ou de contraintes mécaniques entre le guide de lumière 50 et le capteur 30.

## Revendications

1. Afficheur (1) comprenant
- un boitier (10) formé de plusieurs parois (11, 13, 14), optiquement opaques, séparant l'intérieur (INT) du boitier (10) de l'extérieur de celui-ci,
- une unité de génération d'image (20),
- un ensemble optique de projection adapté pour projeter une image générée par l'unité de génération d'image (20), en direction d'une lame semi-transparente pour, avec la lame semi-transparente, former une image virtuelle (IMV) dans le champ de vision d'un utilisateur,- un capteur (30) de lumière, disposé à l'intérieur (INT) dudit boitier (10), adapté pour délivrer un signal représentatif d'une intensité lumineuse qu'il reçoit,
l'afficheur (1) étant adapté à ce que la luminosité d'une image générée par l'unité de génération d'image (20) soit commandée en fonction dudit signal,
**caractérisé en ce que** l'afficheur (1) comprend en outre un guide de lumière (50) situé à l'intérieur (INT) du boitier (10) de l'afficheur (1), présentant une face d'entrée (51) et conformé pour collecter au niveau de sa face d'entrée (51) un rayonnement lumineux provenant de l'extérieur du boitier (10) de l'afficheur, et pour guider ledit rayonnement lumineux jusqu'audit capteur (30) et dans lequel le boitier (10) présentant une face externe (12), ledit boitier (10) présentant une ouverture (16) traversée par ledit rayonnement lumineux, la face d'entrée (51) du guide de lumière (50) étant située au niveau de cette ouverture (16), le boitier (10) comprenant un conduit (19) s'étendant depuis ladite face externe (12) vers l'intérieur (INT) du boitier (10) pour le passage vers l'extérieur du boitier (10) d'un rayonnement lumineux émis par l'unité de génération d'image (20), le conduit (19) étant formé de plusieurs parois (15, 15', 18) optiquement opaques, la face d'entrée (51) du guide de lumière (50) étant située sur ladite paroi 15 du conduit (19), le conduit (19) canalisant un rayonnement lumineux émis par l'unité de génération d'image (20) et renvoyé vers la lame semi-transparente par l'ensemble optique de projection.

2. Afficheur (1) selon la revendication 1, comprenant un ensemble optique de projection (60) adapté pour projeter l'image générée par l'unité de génération d'image (20), en direction d'une lame semi-transparente (70) pour, avec la lame semi-transparente (70), former une image virtuelle (IMV) dans le champ de vision d'un utilisateur, et dans lequel le guide de lumière (50) est distinct de la lame semi-transparente (70).

3. Afficheur (1) selon la revendication 2, dans lequel, le guide de lumière (50) est conformé de sorte que le rayonnement lumineux qu'il est adapté à collecter provient d'une zone (Z1) située approximativement dans la direction dans laquelle est formée ladite image virtuelle (IMV).

4. Afficheur (1) selon l'une des revendications 2 et 3, dans lequel ladite zone (Z1) environne ladite image virtuelle (IMV).

5. Afficheur (1) selon l'une des revendications 3 et 4, dans lequel la face d'entrée (51) du guide de lumière (50) présente une orientation adaptée pour dévier par réfraction le rayonnement lumineux provenant de ladite zone (Z1) de manière à coupler ce rayonnement lumineux dans le guide de lumière (50).

6. Afficheur (1) selon l'une des revendications 3 à 5, dans lequel la face d'entrée (51) du guide de lumière (50) est courbée pour collecter sélectivement le rayonnement lumineux provenant de ladite zone (Z1).

7. Afficheur (1) selon l'une des revendications 2 à 6, dans lequel la face d'entrée (51) du guide de lumière (50) est située, par rapport à la lame semi-transparente (70), d'un côté opposé à ladite image virtuelle (IMV).

8. Afficheur (1) selon l'une des revendications 1 à 7, dans lequel le boitier (10) présente une face externe (12) et présente un renfoncement (100) au niveau de cette face externe (12), la face d'entrée (51) du guide de lumière (50) étant située au niveau de ce renfoncement (100).

9. Afficheur (1) selon l'une des revendications 1 à 8 dans lequel, le boitier (10) présentant une face externe (12), le boitier (10) comprend une paroi (15) s'étendant à partir de cette face externe (12) en direction de l'intérieur (INT) du boitier (10) et en surplomb par rapport à ladite face externe (12), la face d'entrée (51) du guide de lumière (50) étant située au niveau de ladite paroi (15).

10. Afficheur (1) selon l'une des revendications 8 à 9, prise dans la dépendance de l'une des revendications 2 à 7, dans lequel ladite face externe (12) est située, par rapport à l'intérieur (INT) du boitier (10), d'un même côté du boitier (10) que la lame semi-transparente (70) en position d'usage.

11. Afficheur (1) selon l'une des revendications 1 à 10, dans lequel le guide de lumière (50) est disjoint dudit capteur (30).

12. Afficheur (1) selon l'une des revendications 1 à 11, adapté à ce que la luminosité de l'image générée soit d'autant plus grande que l'intensité lumineuse reçue par ledit capteur (30) est grande.

## Patentansprüche

1. Anzeige (1), umfassend
- ein Gehäuse (10), das aus mehreren optisch undurchlässigen Wänden (11, 13, 14) gebildet wird, die den Innenraum (INT) des Gehäuses (10) von dessen Außenraum trennen,
- eine Bilderzeugungseinheit (20),
- eine optische Projektionsanordnung, die geeignet ist, ein von der Bilderzeugungseinheit (20) erzeugtes Bild in Richtung einer halbtransparenten Platte zu projizieren, um mit der halbtransparenten Platte ein virtuelles Bild (IMV) im Sichtfeld eines Benutzers zu bilden, - einen Lichtsensor (30), der im Innenraum (INT) des Gehäuses (10) angeordnet ist und geeignet ist, ein Signal auszugeben, das für eine von ihm empfangene Lichtstärke repräsentativ ist,
wobei die Anzeige (1) dazu geeignet ist, dass die Helligkeit eines von der Bilderzeugungseinheit (20) erzeugten Bildes in Abhängigkeit von dem Signal gesteuert wird,
**dadurch gekennzeichnet, dass** die Anzeige (1) ferner einen Lichtleiter (50) umfasst, der im Innenraum (INT) des Gehäuses (10) der Anzeige (1) gelegen ist, eine Eintrittsseite (51) aufweist und dazu ausgebildet ist, an seiner Eintrittsseite (51) eine vom Außenraum des Gehäuses (10) der Anzeige kommende Lichtstrahlung zu sammeln und die Lichtstrahlung bis zu dem Sensor (30) zu leiten, und wobei das Gehäuse (10) eine Außenseite (12) aufweist, wobei das Gehäuse (10) eine Öffnung (16) aufweist, die von der Lichtstrahlung durchquert wird, wobei die Eintrittsseite (51) des Lichtleiters (50) an dieser Öffnung (16) gelegen ist, wobei das Gehäuse (10) einen Kanal (19) umfasst, der sich von der Außenseite (12) aus zum Innenraum (INT) des Gehäuses (10) erstreckt, für den Durchgang einer von der Bilderzeugungseinheit (20) ausgesendeten Lichtstrahlung zum Außenraum des Gehäuses (10) hin, wobei der Kanal (19) aus mehreren optisch undurchlässigen Wänden (15, 15', 18) gebildet wird, wobei die Eintrittsseite (51) des Lichtleiters (50) an der Wand 15 des Kanals (19) gelegen ist, wobei der Kanal (19) die von der Bilderzeugungseinheit (20) ausgesendete und von der optischen Projektionsanordnung zu der halbtransparenten Platte hin umgeleitete Lichtstrahlung kanalisiert.

2. Anzeige (1) nach Anspruch 1, die eine optische Projektionsanordnung (60) umfasst, die dazu geeignet ist, das von der Bilderzeugungseinheit (20) erzeugte Bild in Richtung einer halbtransparenten Platte (70) zu projizieren, um mit der halbtransparenten Platte (70) ein virtuelles Bild (IMV) im Sichtfeld eines Benutzers zu bilden, und bei welcher der Lichtleiter (50) von der halbtransparenten Platte (70) verschieden ist.

3. Anzeige (1) nach Anspruch 2, bei welcher der Lichtleiter (50) so ausgebildet ist, dass die Lichtstrahlung, zu deren Sammeln er geeignet ist, von einem Bereich (Z1) kommt, der näherungsweise in der Richtung gelegen ist, in der das virtuelle Bild (IMV) gebildet wird.

4. Anzeige (1) nach einem der Ansprüche 2 und 3, bei welcher der Bereich (Z1) das virtuelle Bild (IMV) umgibt.

5. Anzeige (1) nach einem der Ansprüche 3 und 4, bei der die Eintrittsseite (51) des Lichtleiters (50) eine Ausrichtung aufweist, die geeignet ist, durch Brechung die von dem Bereich (Z1) kommende Lichtstrahlung so umzulenken, dass diese Lichtstrahlung in den Lichtleiter (50) eingekoppelt wird.

6. Anzeige (1) nach einem der Ansprüche 3 bis 5, bei der die Eintrittsseite (51) des Lichtleiters (50) gekrümmt ist, um die von dem Bereich (Z1) kommende Lichtstrahlung selektiv zu sammeln.

7. Anzeige (1) nach einem der Ansprüche 2 bis 6, bei der die Eintrittsseite (51) des Lichtleiters (50) bezogen auf die halbtransparente Platte (70) auf einer Seite gelegen ist, die entgegengesetzt zu dem virtuellen Bild (IMV) ist.

8. Anzeige (1) nach einem der Ansprüche 1 bis 7, bei der das Gehäuse (10) eine Außenseite (12) aufweist und eine Vertiefung (100) an dieser Außenseite (12) aufweist, wobei die Eintrittsseite (51) des Lichtleiters (50) an dieser Vertiefung (100) gelegen ist.

9. Anzeige (1) nach einem der Ansprüche 1 bis 8, bei der, wenn das Gehäuse (10) eine Außenseite (12) aufweist, das Gehäuse (10) eine Wand (15) umfasst, die sich von dieser Außenseite (12) aus in Richtung des Innenraums (INT) des Gehäuses (10) und bezogen auf die Außenseite (12) auskragend erstreckt, wobei die Eintrittsseite (51) des Lichtleiters (50) an der Wand (15) gelegen ist.

10. Anzeige (1) nach einem der Ansprüche 8 bis 9 in Abhängigkeit von einem der Ansprüche 2 bis 7, bei der die Außenseite (12) bezogen auf den Innenraum (INT) des Gehäuses (10) in der Verwendungsposition auf einer selben Seite des Gehäuses (10) wie die halbtransparente Platte (70) gelegen ist.

11. Anzeige (1) nach einem der Ansprüche 1 bis 10, bei welcher der Lichtleiter (50) von dem Sensor (30) getrennt ist.

12. Anzeige (1) nach einem der Ansprüche 1 bis 11, die dazu geeignet ist, dass die Helligkeit des erzeugten Bildes umso größer ist, je größer die von dem Sensor (30) empfangene Lichtstärke ist.

## Claims

1. Display (1) comprising:
- a housing (10) formed of a plurality of optically opaque walls (11, 13, 14) that separate the inside (INT) of the housing (10) from the outside thereof,
- an image generation unit (20),
- an optical projection assembly that is suitable for projecting an image generated by the image generation unit (20) in the direction of a semitransparent plate in order to form, with the semitransparent plate, a virtual image (IMV) in the field of view of a user, - a light sensor (30), arranged inside (INT) said housing (10), suitable for delivering a signal that is representative of a luminous intensity that it receives,
the display (1) being designed such that the luminosity of an image generated by the image generation unit (20) is controlled according to said signal,
**characterized in that** the display (1) further comprises a light guide (50) located inside (INT) the housing (10) of the display (1), having an input face (51) and being shaped to collect, at its input face (51), luminous radiation originating outside the housing (10) of the display, and to guide said luminous radiation to said sensor (30), and wherein the housing (10) has an outer face (12), said housing (10) has an opening (16) through which said luminous radiation passes, the input face (51) of the light guide (50) is located at the level of this opening (16), the housing (10) comprises a conduit (19) extending from said outer face (12) toward the inside (INT) of the housing (10) to allow luminous radiation emitted by the image generation unit (20) to pass out of the housing (10), the conduit (19) is formed of a plurality of optically opaque walls (15, 15', 18), the input face (51) of the light guide (50) is located on said wall 15 of the conduit (19), and the conduit (19) channels luminous radiation that is emitted by the image generation unit (20) and sent to the semitransparent plate by the optical projection assembly.

2. Display (1) according to Claim 1, comprising an optical projection assembly (60) that is suitable for projecting the image generated by the image generation unit (20) in the direction of a semitransparent plate (70) in order to form, with the semitransparent plate (70), a virtual image (IMV) in the field of view of a user, and wherein the light guide (50) is distinct from the semitransparent plate (70).

3. Display (1) according to Claim 2, wherein the light guide (50) is shaped such that the luminous radiation that it is designed to collect arises from a zone (Z1) that is located approximately in the direction in which said virtual image (IMV) is formed.

4. Display (1) according to either of Claims 2 and 3, wherein said zone (Z1) surrounds said virtual image (IMV).

5. Display (1) according to either of Claims 3 and 4, wherein the input face (51) of the light guide (50) is oriented in such a way as to deflect the luminous radiation arising from said zone (Z1) by refraction so as to couple said luminous radiation in the light guide (50) .

6. Display (1) according to one of Claims 3 to 5, wherein the input face (51) of the light guide (50) is curved so as to selectively collect the luminous radiation arising from said zone (Z1).

7. Display (1) according to one of Claims 2 to 6, wherein the input face (51) of the light guide (50) is located, with respect to the semitransparent plate (70), on a side opposite said virtual image (IMV).

8. Display (1) according to one of Claims 1 to 7, wherein the housing (10) has an outer face (12) and has a recess (100) at the level of this outer face (12), the input face (51) of the light guide (50) being located at the level of this recess (100).

9. Display (1) according to one of Claims 1 to 8, wherein, the housing (10) having an outer face (12), the housing (10) comprises a wall (15) extending from this outer face (12) in the direction of the inside (INT) of the housing (10) and overhanging said outer face (12), the input face (51) of the light guide (50) being located at the level of said wall (15).

10. Display (1) according to either of Claims 8 and 9, where dependent on one of Claims 2 to 7, wherein said outer face (12) is located, with respect to the inside (INT) of the housing (10), on one and the same side of the housing (10) as the semitransparent plate (70) in the operating position.

11. Display (1) according to one of Claims 1 to 10, wherein the light guide (50) is disjunct from said sensor (30) .

12. Display (1) according to one of Claims 1 to 11, designed such that the luminosity of the generated image increases with the luminous intensity received by said sensor (30).
